(19) **Europäisches Patentamt / European Patent Office / Office européen des brevets**

(11) **EP 4 358 135 A1**

(12) # EUROPEAN PATENT APPLICATION
published in accordance with Art. 153(4) EPC

(43) Date of publication:
**24.04.2024 Bulletin 2024/17**

(21) Application number: **22824708.6**

(22) Date of filing: **10.05.2022**

(51) International Patent Classification (IPC):
**H01L 25/07** (2006.01)  **H01L 25/18** (2006.01)
**H02M 7/48** (2007.01)

(52) Cooperative Patent Classification (CPC):
**H01L 25/07; H01L 25/18; H02M 7/48;**
H01L 2224/0603; H01L 2224/49111;
H01L 2924/19107

(86) International application number:
**PCT/JP2022/019826**

(87) International publication number:
**WO 2022/264714 (22.12.2022 Gazette 2022/51)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **17.06.2021 JP 2021100768**

(71) Applicant: **Hitachi Power Semiconductor Device,
Ltd.
Hitachi-shi, Ibaraki 319-1221 (JP)**

(72) Inventors:
 • **MIMA, Akira**
   **Tokyo 100-8280 (JP)**
 • **ARAI, Taiga**
   **Hitachi-shi, Ibaraki 319-1221 (JP)**
 • **KAWASE, Daisuke**
   **Hitachi-shi, Ibaraki 319-1221 (JP)**
 • **SAITO, Katsuaki**
   **Hitachi-shi, Ibaraki 319-1221 (JP)**
 • **TAKEUCHI, Yujiro**
   **Hitachi-shi, Ibaraki 319-1221 (JP)**

(74) Representative: **Mewburn Ellis LLP
Aurora Building
Counterslip
Bristol BS1 6BX (GB)**

(54) **POWER SEMICONDUCTOR MODULE AND POWER CONVERSION DEVICE**

(57) Provided are a power semiconductor module and a power conversion device that have an internal wiring structure that can reduce electrical vibration that occurs in internal wiring. This power semiconductor module comprises: an upper arm that has a first substrate upon which at least one power semiconductor chip including a first switching element is mounted, and a second substrate upon which at least one power semiconductor chip including a second switching element connected in parallel to the first switching element is mounted; and a lower arm that has a third substrate upon which at least one power semiconductor chip including a third switching element is mounted, and a fourth substrate upon which at least one power semiconductor chip including a fourth switching element connected in parallel to the third switching element is mounted. The power semiconductor module is characterized in that: the upper arm has first wiring that connects the first substrate and the second substrate and connects an emitter or source for the first switching element to an emitter or source for the second switching element; and the first wiring is disposed at a position further away from the lower arm in comparison to the end portion on the far side away from the lower arm of the power semiconductor chip positioned furthest from the lower arm from among the power semiconductor chips of the upper arm.

EP 4 358 135 A1

# FIG. 1

**Description**

Technical Field

The present invention relates to a power semiconductor module and a power conversion device.

Background Art

In recent years, an inverter device as a power conversion device has been required to have a high output density, reduction in size and weight reduction of the power conversion device has been advanced, and there is a strong demand for reduction in size of the power conversion device. The power conversion device has a function of converting direct-current power supplied from a direct-current power source into alternating-current power to be supplied to an alternating-current electric load such as a rotating electrical machine, or a function of converting alternating-current power generated by the rotating electrical machine into direct-current power to be supplied to the direct-current power source. In order to achieve this conversion function, the power conversion device includes an inverter circuit having a power semiconductor module, and the power semiconductor module repeats conduction operation and cutoff operation to perform power conversion from direct-current power to alternating-current power or from alternating-current power to direct-current power.

In order to obtain high output, the power semiconductor module includes a plurality of power semiconductor elements mounted inside connected in parallel. For example, a known power semiconductor module includes a plurality of insulation substrates on which a plurality of power semiconductor elements are mounted are connected in parallel by soldering on a heat dissipation base.

For example, PTL 1 is known as a conventional technique of a power semiconductor module in which a plurality of power semiconductor elements are mounted and connected in parallel. PTL 1 proposes an inverter module including: a first insulation substrate having a first switching element; a second insulation substrate having a second switching element connected in parallel to the first switching element; and a wiring board electrically connected to common wiring patterns of the first switching element in the first insulation substrate and the second switching element in the second insulation substrate, in which the common wiring patterns are connected to each other by a substrate-to-substrate connection wiring member having an inductance formed in an energization path of the first switching element in the wiring board and an inductance smaller than an inductance formed in an energization path of the second switching element in the wiring board. According to PTL 1, by internal substrate-to-substrate wiring having an inductance smaller than that of external wiring, the wiring inductance can be reduced to improve the current imbalance.

PTL 2 discloses a 2in1 module 144 that forms a half-bridge circuit.

Citation List

Patent Literatures

PTL 1: JP 2009-278772 A
PTL 2: JP 2020-124030 A

Summary of Invention

Technical Problem

In order to further reduce the size in a power conversion circuit, as in PTL 2 described above, a 2in1 module in which upper and lower arms are mounted on the same power semiconductor module has been proposed, and there is an increasing demand for a low inductance of internal wiring.

In the module in which the low inductance of internal wiring is thus achieved, a voltage imbalance occurs between insulation substrates connected in parallel during the switching operation of the power semiconductor element due to variation in the internal wiring inductance, and this voltage imbalance may trigger LC resonance between a parasitic capacitance C of the power semiconductor element and a parasitic inductance L existing in the electric circuit. When the LC resonance is amplified, the oscillating voltage gradually increases, and the power semiconductor element is eventually destroyed.

Here, PTL 2 describes that a sixth main electrode 14 and an eighth main electrode 16 are connected by a twelfth conductor 54 in order to suppress gate voltage oscillation during switching. However, PTL 2 only discloses the twelfth conductor 54 disposed at a position on a substantially straight line between the sixth main electrode 14 and the eighth main electrode 16.

As a result of studies by the present inventors, it has been found that the effect of suppressing gate voltage oscillation is not necessarily sufficient in the configuration described in PTL 2.

The present invention has been made in view of the above problems, and an object thereof is to provide an internal wiring structure that can reduce electric oscillation generated in internal wiring of a power semiconductor module.

Solution to Problem

One aspect of the present invention for solving the above problems is a power semiconductor module including: an upper arm including a first substrate on which at least one power semiconductor chip including a first switching element is mounted and a second substrate on which at least one power semiconductor chip including a second switching element connected in parallel to the first switching element is mounted; and a lower arm including a third substrate on which at least one power semiconductor chip including a third switching element is mounted and a fourth substrate on which at least one power semiconductor chip including a fourth switching element connected in parallel to the third switching element is mounted, in which the upper arm includes first wiring connecting the first substrate and the second substrate, the first wiring connecting an emitter or a source of the first switching element and an emitter or a source of the second switching element, and the first wiring is disposed at a position farther from the lower arm than an end part on a side farther from the lower arm of a power semiconductor chip at a position farthest from the lower arm among power semiconductor chips of the upper arm.

Advantageous Effects of Invention

According to the present invention, it is possible to provide an internal wiring structure that can reduce electric oscillation generated in internal wiring of a power semiconductor module.

Specific effects of the present invention are as follows.

A) It is possible to increase the inductance of collector-to-collector wiring (or drain-to-drain wiring, the same hereinafter) of the power semiconductor element of the lower arm while reducing the inductance of emitter-to-emitter wiring (or source-to-source wiring, the same hereinafter) of the power semiconductor element of the upper arm.

B) When the collector-to-collector inductance is increased and the emitter-to-emitter inductance is decreased, the substrate-to-substrate voltage oscillation caused by the impedance difference between the parallel-connected substrates can be directed to attenuation.

Brief Description of Drawings

[FIG. 1] FIG. 1 is an internal wiring structure diagram of a power semiconductor module of the present invention.

[FIG. 2] FIG. 2 is an equivalent circuit diagram of internal wiring of the power semiconductor module of the present invention.

[FIG. 3] FIG. 3 is a simple equivalent circuit diagram of the internal wiring of the power semiconductor module of the present invention.

[FIG. 4] FIG. 4 is an image view of a complex number plane of a solution S.

[FIG. 5] FIG. 5 is a view illustrating a combination condition of Lpos and Lneg for attenuation.

[FIG. 6] FIG. 6 is a comparative view of a conventional internal wiring structure and an internal wiring structure of the present invention.

[FIG. 7] FIG. 7 illustrates operation waveforms of the power semiconductor element when the conventional internal wiring structure and the internal wiring structure of the present invention are used.

[FIG. 8] FIG. 8 illustrates a wiring structure of a power semiconductor module of Example 3 of the present invention.

[FIG. 9] FIG. 9 illustrates a wiring structure of a power semiconductor module of Example 4 of the present invention.

[FIG. 10] FIG. 10 illustrates a wiring structure of a power semiconductor module of Example 5 of the present invention.

Description of Embodiments

Hereinafter, a wiring structure of the power conversion device according to the present invention will be described with reference to the drawings. In each figure, identical elements are given the identical reference signs, and redundant description is omitted.

[Example 1]

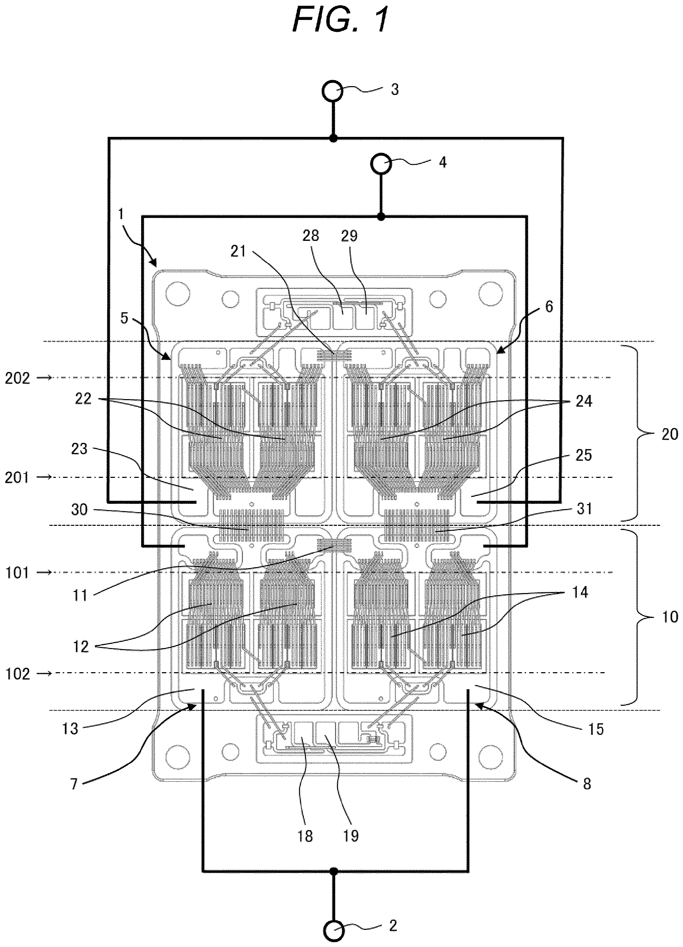

FIG. 1 is an internal wiring structure diagram of the power semiconductor module of the present invention. As illustrated in FIG. 1, the internal wiring structure of a power semiconductor module 1 of the present invention includes an upper arm portion 20 in which a plurality of switching elements are connected in parallel, and a lower arm portion 10 in which a plurality of switching elements are connected in parallel similarly. The upper arm portion 20 and the lower arm portion 10 are connected by wiring 30 and wiring 31, and are connected to an alternating-current terminal 2.

A first insulation wiring board 5 of the upper arm portion (hereinafter, also referred to as "first insulation wiring board") on which at least one power semiconductor chip including a switching element is mounted and a second insulation wiring board 6 of the upper arm portion on which at least one power semiconductor chip including a switching element is mounted are connected in parallel to the upper arm portion 20. Here, the switching element of the first insulation wiring board 5 of the upper arm portion and the switching element of the second insulation wiring board 6 of the upper arm portion (hereinafter, also referred to as "second insulation wiring board") are connected in parallel.

FIG. 1 illustrates an example in which an IGBT is used as a switching element, and two IGBT chips and two diode chips connected in parallel to each other are mounted on one insulation wiring board as a power semiconductor chip. Therefore, four IGBT chips and four diode chips are mounted on the entire upper arm portion 20. Note that the number of IBGT chips and diode chips may be other than four. One IGBT chip and one diode chip may be mounted on one insulation wiring board. Not limited to the IGBT used as the switching element, a MOSFET may be used as the switching element, and only a MOSFET chip or a MOSFET chip and a diode chip may be mounted as the power semiconductor chip. In the following description, an example in which an IGBT is used as a switching element is described, and thus, the terms emitter and collector are used for description. However, when a MOSFET is used as a switching element, the emitter is only required to be read as a source, and the collector is only required to be read as a drain.

The first insulation wiring board 5 of the upper arm portion includes a wiring portion 22 for connecting an emitter portion (or a source portion, the same hereinafter) of the switching element and a wiring portion 23 for connecting a collector portion (or a drain portion, the same hereinafter) of the switching element. The second insulation wiring board 6 of the upper arm portion includes a wiring portion 24 for connecting the emitter portion of the switching element and a wiring portion 25 for connecting the collector portion of the switching element. The collector wiring portion 23 of the first insulation wiring board 5 of the upper arm portion and the collector wiring portion 25 of the second insulation wiring board 6 of the upper arm portion are connected to a positive electrode terminal 3.

In the upper arm portion 20, an upper arm portion gate wiring 28 and an upper arm portion emittance wiring 29 are disposed as control signal wiring of the switching elements mounted on the insulation wiring board of the upper arm.

Similarly to the upper arm portion 20, a third insulation wiring board 7 of the lower arm portion (hereinafter, also referred to as "third insulation wiring board") on which at least one power semiconductor chip including a switching element is mounted and a fourth insulation wiring board 8 of the lower arm portion on which at least one power semiconductor chip also including a switching element is mounted are connected in parallel to the lower arm portion 10.

FIG. 1 illustrates an example in which four IGBT chips and four diode chips are mounted in the entire lower arm portion 10, similarly to the upper arm portion 20, but the present invention is not limited to this as already described in the description of the upper arm portion 20.

The third insulation wiring board 7 of the lower arm portion includes a wiring portion 12 for connecting the emitter portion of the switching element and a wiring portion 13 for connecting the collector portion of the switching element. The fourth insulation wiring board 8 of the lower arm portion (hereinafter, also referred to as "fourth insulation wiring board") includes a lower arm emitter wiring portion 14 for connecting the emitter portion of the switching element (hereinafter, also referred to as "emitter wiring portion") and a lower arm collector wiring portion 15 for connecting the collector portion of the switching element (hereinafter, also referred to as "collector wiring portion").

The emitter wiring portion 12 of the third insulation wiring board 7 of the lower arm portion and the emitter wiring portion 14 are connected to a negative electrode terminal 4.

In the lower arm portion 10, a lower arm portion gate wiring 18 and a lower arm portion emitter sense wiring 19 are disposed as control signal wiring of the switching elements mounted on the insulation wiring board of the lower arm.

Furthermore, the upper arm portion 20 includes, between the first insulation wiring board 5 of the upper arm portion and the second insulation wiring board 6 of the upper arm portion, a substrate-to-substrate wiring 21 of the upper arm for connecting the emitter wiring portion 22 of the upper arm and the emitter wiring portion 24 of the upper arm between the insulation substrates.

The lower arm portion 10 includes, between the third insulation wiring board 7 of the lower arm portion and the fourth insulation wiring board 8 of the lower arm portion, a lower arm substrate-to-substrate wiring portion 11 for connecting the lower arm emitter wiring portion 12 and the lower arm emitter wiring portion 14 between the insulation substrates.

A plurality of power semiconductor chips are mounted on the first insulation wiring board 5 and the second insulation wiring board 6 of the upper arm portion 20. Of the plurality of chips, an end part on a side close to the lower arm portion 10 of a chip present in a position closest to the lower arm portion 10 is a chip end part 201, and an end part on a side far from the lower arm portion 10 of a chip present in a position farthest from the lower arm portion 10 is a chip end part 202.

A plurality of power semiconductor chips are mounted on the third insulation wiring board 7 and the fourth insulation wiring board 8 of the lower arm portion 10. Of the plurality of chips, an end part on a side close to the upper arm portion 20 of a chip present in a position closest to the upper arm portion 20 is a chip end part 101, and an end part on a side far from the upper arm portion 20 of a chip present in a position farthest from the upper arm portion 20 is a chip end part 102.

The present invention is characterized in that the substrate-to-substrate wiring (first wiring) 21 of the upper arm portion 20 is disposed in a direction (far position) away from the lower arm than the chip end part 202 that is far from the lower arm.

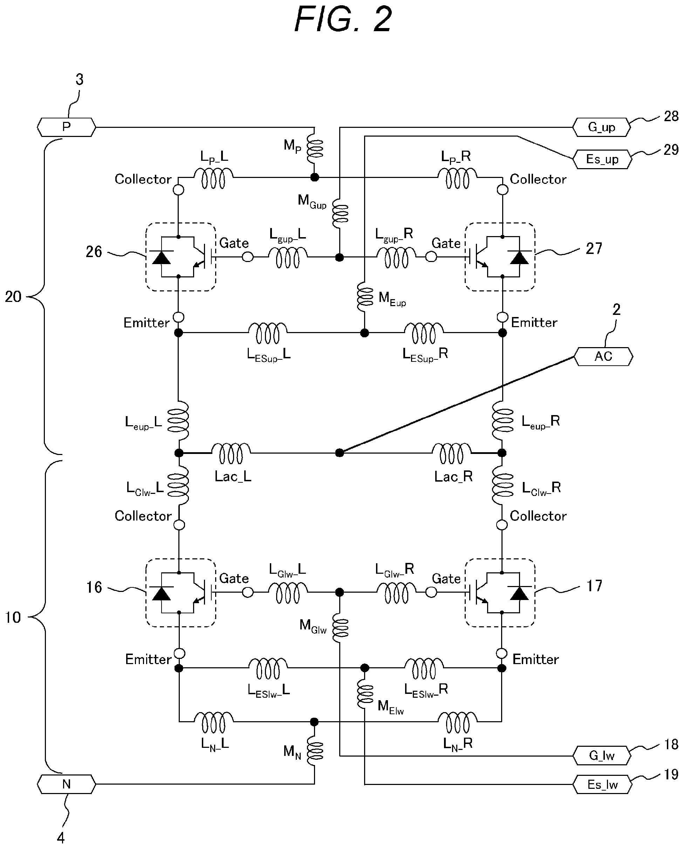

Next, an equivalent circuit diagram of the internal wiring structure of the power semiconductor module according to the present invention will be described with reference to FIG. 2. FIG. 2 is an equivalent circuit diagram of the internal wiring structure of the power semiconductor module of the present invention. In FIG. 2, the upper arm portion 20 and the lower arm portion 10 are disposed corresponding to FIG. 1.

The plurality of power semiconductor elements (here, IGBT and diode) mounted on the first insulation wiring board 5 of the upper arm portion 20 illustrated in FIG. 1 are collectively referred to as power semiconductor elements 26 in FIG. 2.

The plurality of power semiconductor elements mounted on the second insulation wiring board 6 of the upper arm portion 20 illustrated in FIG. 1 are collectively referred to as power semiconductor elements 27 in FIG. 2.

The plurality of power semiconductor elements mounted on the third insulation wiring board 7 of the lower arm portion 10 illustrated in FIG. 1 are collectively referred to as power semiconductor elements 16 in FIG. 2.

The plurality of power semiconductor elements mounted on the third insulation wiring board 7 of the lower arm portion 10 illustrated in FIG. 1 are collectively referred to as power semiconductor elements 17 in FIG. 2.

A parasitic inductance component exists due to wiring between the upper arm power semiconductor elements 26, the upper arm power semiconductor elements 27, and the positive electrode terminal 3.

Due to the collector wiring portion 23 and the collector wiring portion 25 of the upper arm between the first insulation wiring board 5 and the second insulation wiring board 6 illustrated in FIG. 1, inductance components LP_L and LP_R in FIG. 2 are formed and Mp is formed as mutual inductance.

Due to the upper arm portion gate wiring 28 illustrated in FIG. 1, parasitic inductance components Lgup_L and Lgup_R of the upper arm gate wiring illustrated in FIG. 2 are formed, and MGup is formed as mutual inductance.

On the other hand, due to the upper arm portion emittance wiring 29 illustrated in FIG. 1, parasitic inductance components LESup_L and LESup_R of the upper arm emitter sense wiring illustrated in FIG. 2 are formed, and MEup is formed as mutual inductance.

A parasitic inductance component exists due to wiring between the power semiconductor elements 16 of the lower arm, the power semiconductor elements 17 of the lower arm, and the negative electrode terminal 4.

Due to the emitter wiring portion 12 of the lower arm and the emitter wiring portion 14 of the lower arm between the third insulation wiring board 7 and the fourth insulation wiring board 8 illustrated in FIG. 1, inductance components LN_L and LN_R in FIG. 2 are formed, and MN is formed as mutual inductance.

Due to the lower arm portion gate wiring 18 illustrated in FIG. 1, parasitic inductance components Lglw_L and Lglw_R of the lower arm gate wiring illustrated in FIG. 2 are formed, and MGlw is formed as mutual inductance.

On the other hand, due to the lower arm portion emitter sense wiring 19 illustrated in FIG. 1, parasitic inductance components LESlw_L and LESlw_R of the lower arm emitter sense wiring illustrated in FIG. 2 are formed, and MElw is formed as mutual inductance.

Next, the parasitic inductance between the emitters of the upper arm and between the collectors of the lower arm will be described. As described in FIG. 1, the upper arm portion 20 includes the emitter wiring portion 22 of the upper arm and the emitter wiring portion 24 of the upper arm, and the lower arm portion 10 includes the collector wiring portion 13 of the lower arm and the collector wiring portion 15 of the lower arm.

The emitter wiring portion 22 of the upper arm and the collector wiring portion 13 of the lower arm are connected by wiring 30 between the upper and lower arms (wiring between the first insulation wiring board of the upper arm and the third insulation wiring board of the lower arm) illustrated in FIG. 1. The emitter wiring portion 24 of the upper arm and the collector wiring portion 15 of the lower arm are connected by wiring 31 between the upper and lower arms (wiring between the third insulation wiring board of the upper arm and the fourth insulation wiring board of the lower arm) illustrated in FIG. 1.

As described in FIG. 1, the emitter wiring portion 22 of the upper arm and the emitter wiring portion 24 of the upper arm are connected by the substrate-to-substrate wiring 21 of the upper arm.

Therefore, the emitter of the upper arm and the collector of the lower arm are connected by these wiring groups (the upper arm emitter wiring portions 22 and 24, the lower arm collector wiring portions 13 and 15, the wiring 30 between the upper and lower arms and the wiring 31 between the upper and lower arms, and the upper arm substrate-to-substrate wiring 21).

Due to these wiring groups, parasitic inductance components Leup_L and Leup_R, Lac_L and Lac_R, and LClw_L and LClw_R illustrated in FIG. 2 are formed, respectively.

Lac_L and Lac_R are parasitic inductance components of the substrate-to-substrate wiring 21 of the upper arm, Leup_L and Leup_R are parasitic inductance components of the emitter wiring portions 22 and 24 of the upper arm, and LClw_L and LClw_R are parasitic inductance components of the collector wiring portions 13 and 15 of the lower arm.

As illustrated in FIG. 1 of the present invention, by disposing the substrate-to-substrate wiring of the upper arm at a position farther from the lower arm than the chip end part 202 farther from the lower arm, that is, by disposing the substrate-to-substrate wiring 21 at a position as far from the lower arm as possible, it is possible to decrease the emitter wiring inductances Leup_L and Leup_R of the upper arm, and increase the collector wiring inductances LClw_L and LClw_R of the lower arm, thereby making it possible to give a significant difference in the magnitude relationship. Therefore, it becomes possible to obtain a parasitic inductance component satisfying the relationship of the following expressions.

[Expression 1]

$$L_{eup\_}L \ < \ L_{Clw\_}L$$

[Expression 2]

$$L_{eup\_}R \ < \ L_{Clw\_}R$$

Therefore, the internal wiring structure disclosed in FIG. 1 of the present invention becomes possible to intentionally increase the collector-to-collector parasitic inductance of the lower arm belonging to the same wiring group while making the emitter-to-emitter parasitic inductance of the upper arm belonging to the same wiring group to a small value.

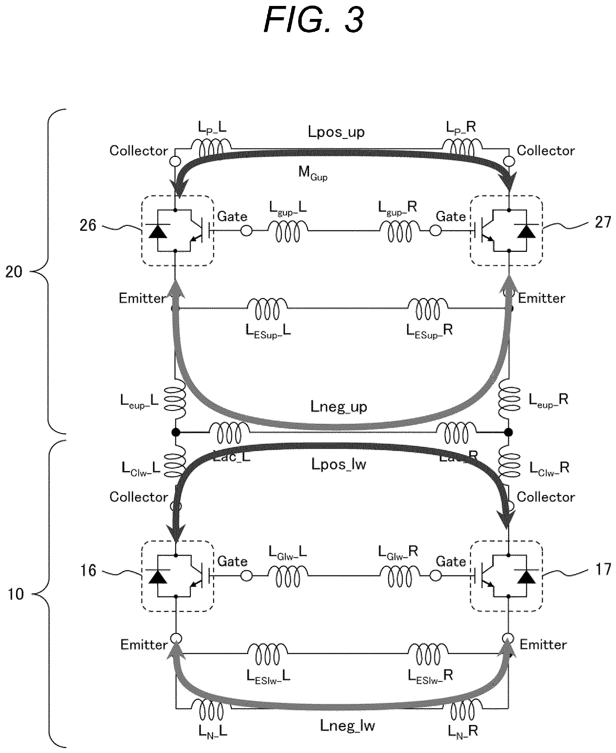

FIG. 3 is a simple equivalent circuit diagram of the present invention. At the time of operation of power semiconductor elements connected in parallel, electric oscillation may occur due to a shift in operation timing of the power semiconductor elements or a parasitic inductance shift on a parallel equivalent circuit.

For example, in a case where a voltage imbalance occurs between the power semiconductor elements 26 and the power semiconductor elements 27 of the upper arm in the equivalent circuit illustrated in FIG. 3, a radio frequency current is supplied so that the parasitic inductance around the power semiconductor elements 26 and the power semiconductor elements 27 cancels the potential difference caused by the voltage imbalance.

The radio frequency current causes energy exchange between the parasitic capacitance of the power semiconductor elements 26 and the power semiconductor elements 27, resulting in an occurrence of LC resonance. This LC resonance is what is called electric oscillation. When this electric oscillation is amplified, the withstand voltage of the power semiconductor element is eventually exceeded, and the element may be broken.

In the equivalent circuit illustrated in FIG. 3, the parasitic inductance on the collector side of the upper arm portion 20 is Lpos_up, and the parasitic inductance on the emitter side of the upper arm portion 20 is Lneg_up. Similarly, regarding the lower arm portion 10, the parasitic inductance on the collector side is Lpos_lw, and the parasitic inductance on the emitter side of the lower arm portion 10 is Lneg_lw.

For example, a transient state e(t) of the collector-to-collector/emitter-to-emitter voltage of the power semiconductor element illustrated in FIG. 3 is formulated as follows.

[Expression 3]

$$e(t) = A \cdot \exp[\{S + j\omega\}t]$$

The solution S of the transient state e(t) can be replaced by the following expression.

[Expression 4]

$$S = f(Lpos, Lneg) \pm j\omega \cdot g(Lpos, Lneg)$$

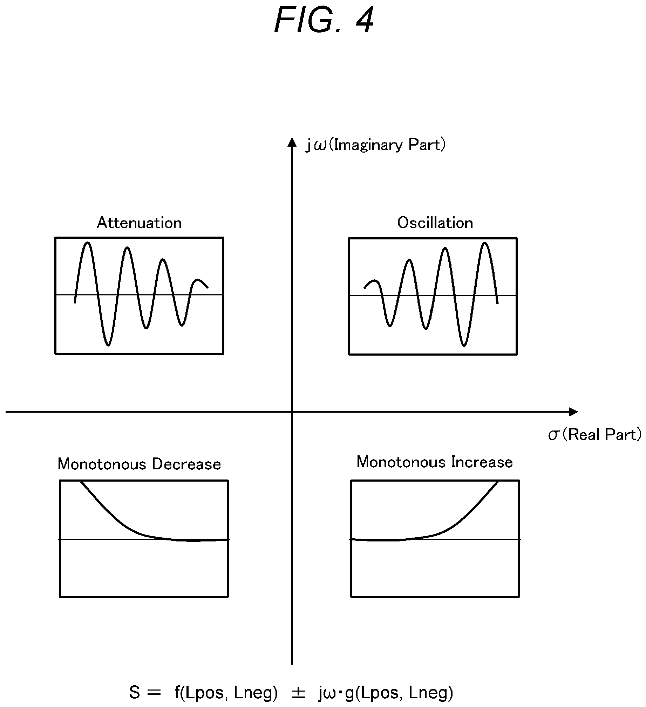

FIG. 4 is an image view of a complex number plane of the solution S. The solution S is a solution that can be expressed by a complex number, and is expressed in a polar coordinate plane as illustrated in FIG. 4. In FIG. 4, the horizontal axis represents a real part of the solution S, and the vertical axis represents an imaginary part of the solution S. In a case where the solution S is not on a real axis, there are two solutions of complex conjugate.

According to FIG. 4, when both the real part and the imaginary part of the solution S are positive, the voltage e(t) in the transient state oscillates (Oscillation). On the other hand, when the real part of the solution S is negative and the imaginary part is positive, the voltage e(t) in the transient state becomes attenuated (Attenuation). When the real part of the solution S is positive and the imaginary part is negative, the voltage e(t) in the transient state monotonously increases (Monotonous Increase). Furthermore, when both the real part and the imaginary part of the solution S are negative, the voltage e(t) in the transient state monotonously decreases(Monotonous Decrease).

Therefore, in order to attenuate the voltage e(t) in the transient state, the real part of the solution S needs to be negative.

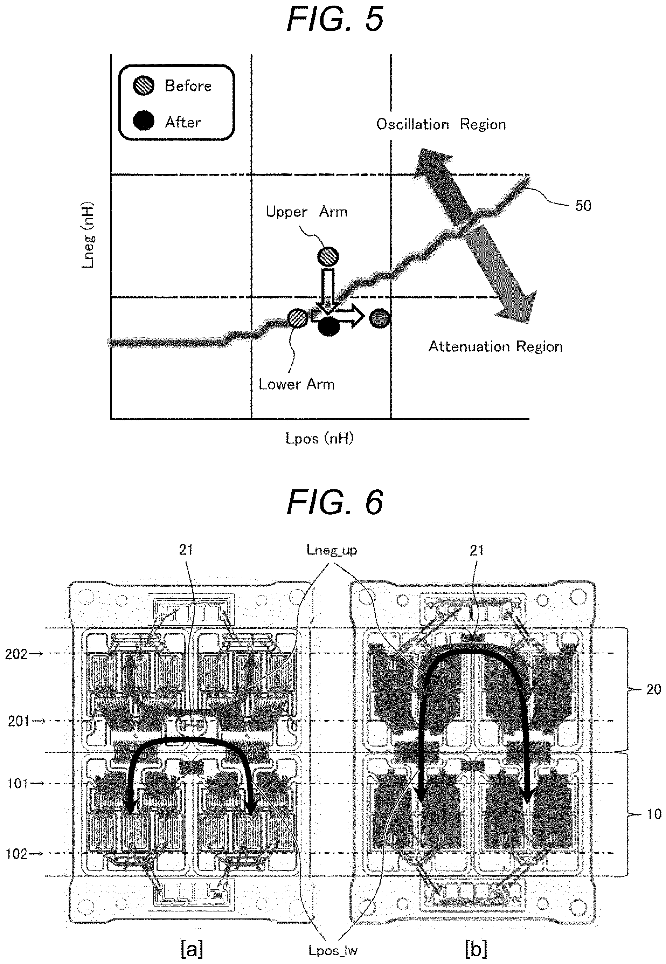

FIG. 5 is a view illustrating a combination condition of Lpos and Lneg for attenuation. In FIG. 5, the horizontal axis represents the parasitic inductance Lpos on the collector side, and the vertical axis represents the parasitic inductance Lneg between the emitters. FIG. 5 is a view illustrating a combination condition of Lpos and Lneg for attenuation.

When Lpos is increased and Lneg is decreased with a combination condition 50 of Lpos and Lneg for attenuation in FIG. 5 as a boundary, the real part of the solution S becomes negative, and the voltage e(t) in the transient state can become attenuated.

Therefore, in the simple equivalent circuit of FIG. 3, both the upper arm portion 20 and the lower arm portion 10 can become attenuated even if electric oscillation is generated by increasing the parasitic inductance Lpos on the collector side and decreasing the parasitic inductance Lneg on the emitter side.

As illustrated in FIGS. 1 and 2, by adopting the internal wiring structure of the present invention, it is possible to distribute the wiring parasitic inductance between the upper and lower arms, which are the same wiring group, such that the emitter-to-emitter parasitic inductance of the upper arm is small and the collector-to-collector parasitic inductance of the lower arm is large. Therefore, according to the internal wiring structure disclosed in the present invention, it is possible to individually control the relationship between Lpos and Lneg regarding each of the upper arm and the lower arm to make it in the attenuation region (combination of Lpos and Lneg in which the real part of the solution is negative) in FIG. 5.

[Example 2]

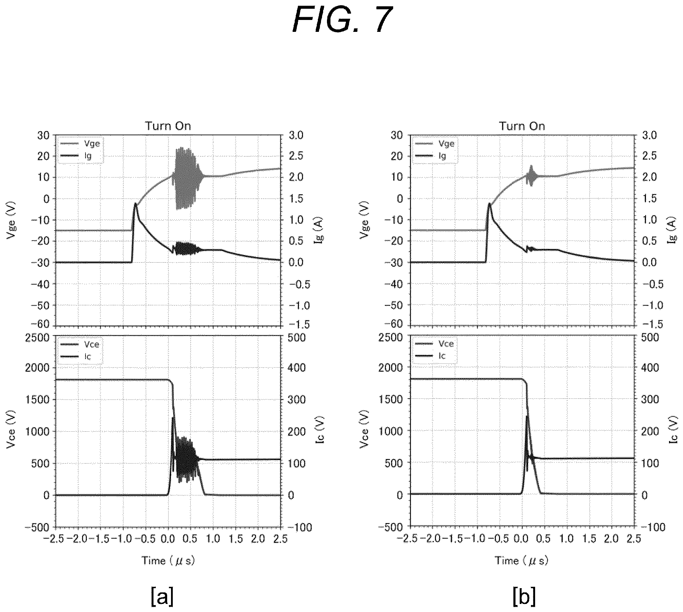

FIG. 6 is a comparative view of the conventional internal wiring structure and the internal wiring structure of the present invention, and FIG. 7 illustrates operation waveforms of the power semiconductor element when the conventional internal wiring structure and the internal wiring structure of the present invention are used. The effects of the present invention will be described with reference to FIGS. 6 and 7. FIG. 6 illustrates configuration examples of the conventional wiring structure and the wiring structure of the present invention. Here, FIG. 6[a] is the conventional internal wiring structure, and FIG. 6[b] is the internal wiring structure of the present invention. FIG. 7[a] illustrates an electric oscillation analysis result in the conventional internal wiring structure, and FIG. 7[b] illustrates an electric oscillation analysis result in the internal wiring structure of the present invention.

The conventional internal wiring structure of FIG. 6[a] is substantially the same as the mounting positions of the first insulation wiring board 5 to the fourth insulation wiring board 8 respectively mounted on the upper arm portion 20 and the lower arm portion 10 of the internal wiring structure of Example 1 (FIG. 6[b]) of the present invention.

The conventional internal wiring structure of FIG. 6[a] and the internal wiring structure of Example 1 of the present invention are different from each other in the position of the substrate-to-substrate wiring 21 of the upper arm portion.

In the conventional internal wiring structure of FIG. 6[a], the substrate-to-substrate wiring 21 of the upper arm portion is disposed on a side closer to the lower arm than the chip end part 201 closer to the lower arm of the upper arm portion. On the other hand, in Example 1 of the present invention, as described above, the substrate-to-substrate wiring 21 of the upper arm portion is disposed on the side farther from the lower arm than the chip end part 202 farther from the lower arm of the upper arm portion.

Therefore, in the conventional internal wiring structure of FIG. 6[a], the path lengths of the emitter-to-emitter wiring path of the upper arm and the collector-to-collector wiring path of the lower arm become substantially equal. Therefore, as the parasitic inductance of the wiring path between the substrates, the collector-to-collector parasitic inductance Lpos_lw of the lower arm and the emitter-to-emitter inductance Lneg_up of the upper arm become substantially equal.

On the other hand, according to the internal wiring structure of Example 1 of the present invention, since the substrate-to-substrate wiring 21 of the upper arm portion is disposed in a direction farther from the lower arm, the collector-to-collector wiring path of the lower arm becomes longer than the emitter-to-emitter wiring path of the upper arm. Therefore, as the parasitic inductance of the wiring path between the substrates, the collector-to-collector parasitic inductance Lpos_lw of the lower arm becomes larger than the emitter-to-emitter inductance Lneg_up of the upper arm.

According to Example 1, by increasing the collector-to-collector parasitic inductance Lpos and decreasing the emitter-to-emitter parasitic inductance Lneg, attenuation can be achieved even if electric oscillation occurs. Therefore, the internal wiring structure of Example 1 of the present invention has an oscillation reduction effect as compared with the conventional internal wiring structure of FIG. 6[a].

In FIG. 5, Before indicates the relationship between Lpos and Lneg of the upper arm and the lower arm in FIG. 6[a], and After indicates the relationship between Lpos and Lneg of the upper arm and the lower arm in FIG. 6[b] after a countermeasure. As illustrated in FIG. 5, the attenuation region can be achieved by the configuration of FIG. 6[b].

FIG. 7[a] is a circuit analysis result of the drive waveform when the power semiconductor elements connected in parallel are caused to perform switching operation using the parasitic inductance of the internal wiring structure of FIG. 6[a]. This result exhibits that a gate voltage waveform Vge, a gate current waveform Ig, a main voltage waveform Vce, and a main current waveform Ic of the power semiconductor element are greatly oscillated.

On the other hand, FIG. 7[b] is a circuit analysis result of the drive waveform when the power semiconductor elements connected in parallel are caused to perform switching operation using the parasitic inductance of the internal wiring structure of Example 1 of the present invention of FIG. 6[b].

This result exhibits that when the internal wiring structure of Example 1 of the present invention is used, minute oscillation is observed in the gate voltage Vge, but a large oscillation waveform is not observed in the main voltage Vce and the main current Ic of the power semiconductor elements connected in parallel.

Therefore, the electric oscillation during the switching operation can be suppressed by adopting the internal wiring structure of Example 1 of the present invention.

[Example 3]

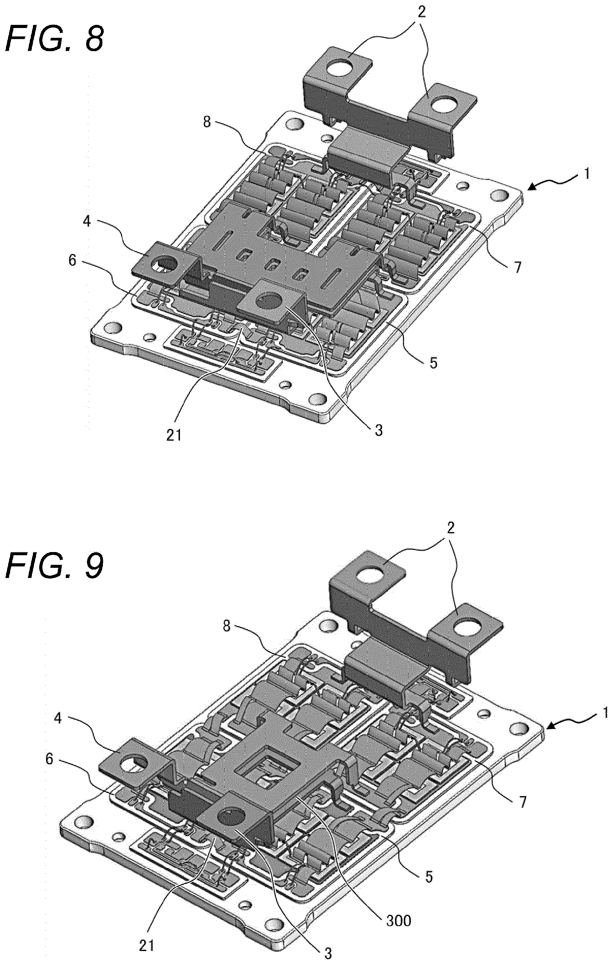

FIG. 8 is a wiring structure of a power semiconductor module of Example 3 of the present invention.

The power semiconductor module of FIG. 8 uses the internal wiring structure of the power semiconductor module 1 of the present invention of Example 1, and the alternating-current terminal 2, the positive electrode terminal 3, and the negative electrode terminal 4 are disposed as illustrated in FIG. 8.

The first insulation wiring board 5 and the second insulation wiring board 6 of the upper arm portion, and the third insulation wiring board 7 and the fourth insulation wiring board 8 of the lower arm portion are disposed at the positions illustrated in FIG. 8. The substrate-to-substrate wiring 21 of the upper arm portion is disposed at the position illustrated in FIG. 8, is disposed on the first insulation wiring board 5 and the second insulation wiring board 6 of the upper arm portion, and is disposed at a position farthest from the third insulation wiring board 7 and the fourth insulation wiring board 8 of the lower arm portion.

Note that the substrate-to-substrate wiring 21 of the upper arm portion can be configured by one or more wire bonding, and can be wired as long as it is a metal conductor as ribbon bonding wiring.

[Example 4]

FIG. 9 is a wiring structure of a power semiconductor module of Example 4 of the present invention.

The difference between the power semiconductor modules illustrated in FIG. 8 and FIG. 9 of Example 4 is that an insulation distance 300 between the positive electrode terminal 3 and the negative electrode terminal 4 is larger in Example 4 than in FIG. 8. By increasing the insulation distance, it becomes possible to improve the insulation resistance of the power semiconductor module of Example 4.

By disposing the substrate-to-substrate wiring 21 of the upper arm portion at the same position as in Example 3, an electric oscillation suppression effect can be expected.

[Example 5]

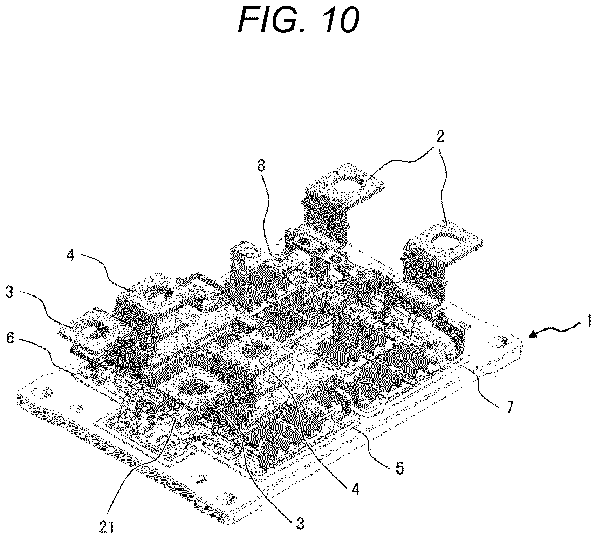

FIG. 10 is a wiring structure of a power semiconductor module of Example 5 of the present invention.

The difference between the power semiconductor modules illustrated in FIGS. 8 and 9 and FIG. 10 of Example 5 is that two positive electrode terminals 3 and two negative electrode terminals 4 are mounted in Example 5. By increasing the number of the positive electrode terminal 3 and the negative electrode terminal 4, the power semiconductor module described in Example 5 supports a large-output current specification.

By disposing the substrate-to-substrate wiring 21 of the upper arm portion at the same position as in Examples 3 to 4, an electric oscillation suppression effect can be expected.

As described above, it has been presented that according to the present invention, it is possible to provide an internal wiring structure that can reduce electric oscillation generated in internal wiring of a power semiconductor module.

Note that the present invention is not limited to the above-described examples, and includes various modifications. For example, the above-described examples have been described in detail for easy understanding of the present invention, and are not necessarily limited to those having all the configurations. It is also possible to replace part of the configuration of one example with the configuration of another example, and it is also possible to add the configuration of another example to the configuration of one example. A part of the configuration of each example can be added to, deleted from, or replaced by another configuration.

Reference Signs List

1 power semiconductor module
2 alternating-current terminal
3 positive electrode terminal
4 negative electrode terminal
5 first insulation wiring board of upper arm portion
6 second insulation wiring board of upper arm portion
7 third insulation wiring board of lower arm portion
8 fourth insulation wiring board of lower arm portion
10 lower arm portion
11 substrate-to-substrate wiring of lower arm portion
12 lower arm emitter wiring portion on third insulation wiring board
13 lower arm collector wiring portion on third insulation wiring board
14 lower arm emitter wiring portion on fourth insulation wiring board
15 lower arm collector wiring portion on fourth insulation wiring board
16 lower arm power semiconductor element on third insulation wiring board
17 lower arm power semiconductor element on fourth insulation wiring board
18 lower arm portion gate wiring
19 lower arm portion emitter sense wiring
20 upper arm portion
21 upper arm portion substrate-to-substrate wiring
22 upper arm emitter wiring portion on first insulation wiring board
23 upper arm collector wiring portion on first insulation wiring board
24 upper arm emitter wiring portion on second insulation wiring board
25 upper arm collector wiring portion on second insulation wiring board
26 upper arm power semiconductor element on first insulation wiring board
27 upper arm power semiconductor element on second insulation wiring board
28 upper arm portion gate wiring
29 upper arm portion emittance wiring
30 wiring between first insulation wiring board of upper arm and third insulation wiring board of lower arm
31 wiring between second insulation wiring board of upper arm and fourth insulation wiring board of lower arm
50 combination condition of Lpos and Lneg for attenuation
101 chip end part closer to upper arm in lower arm portion
102 chip end part farther from upper arm in lower arm portion
201 chip end part closer to lower arm in upper arm portion
202 chip end part farther from lower arm in upper arm portion

**Claims**

**1.** A power semiconductor module comprising:

an upper arm including a first substrate on which at least one power semiconductor chip including a first switching element is mounted and a second substrate on which at least one power semiconductor chip including a second switching element connected in parallel to the first switching element is mounted; and

a lower arm including a third substrate on which at least one power semiconductor chip including a third switching element is mounted and a fourth substrate on which at least one power semiconductor chip including a fourth switching element connected in parallel to the third switching element is mounted,

wherein the upper arm includes first wiring connecting the first substrate and the second substrate, the first wiring connecting an emitter or a source of the first switching element and an emitter or a source of the second switching element, and

the first wiring is disposed at a position farther from the lower arm than an end part on a side farther from the lower arm of a power semiconductor chip at a position farthest from the lower arm among power semiconductor chips of the upper arm.

2. The power semiconductor module according to claim 1 comprising:

second wiring connecting the first substrate and the third substrate, the second wiring connecting the emitter or the source of the first switching element and a collector or a drain of the third switching element;

third wiring connecting the second substrate and the fourth substrate, the third wiring connecting the emitter or the source of the second switching element and a collector or a drain of the fourth switching element; and

fourth wiring connecting the third substrate and the fourth substrate, the fourth wiring connecting an emitter or a source of the third switching element and an emitter or a source of the fourth switching element,

wherein a total impedance of the first wiring, the second wiring, and the third wiring is larger than an impedance of the fourth wiring.

3. The power semiconductor module according to claim 2, wherein

a total path length of the first wiring, the second wiring, and the third wiring is longer than a path length of the fourth wiring.

4. The power semiconductor module according to claim 1, wherein

the first switching element includes a plurality of switching elements connected in parallel mounted on the first substrate.

5. The power semiconductor module according to claim 1 comprising:

a positive electrode terminal connected to the first substrate and the second substrate;

a negative electrode terminal connected to the third substrate and the fourth substrate; and

an alternating-current terminal electrically connected to wiring between the upper arm and the lower arm.

6. A power conversion device on which the power semiconductor module according to any one of claims 1 to 5 is mounted.

# FIG. 1

# FIG. 2

# FIG. 3

# FIG. 4

jω(Imaginary Part)

Attenuation

Oscillation

σ(Real Part)

Monotonous Decrease

Monotonous Increase

$$S = f(Lpos, Lneg) \pm j\omega \cdot g(Lpos, Lneg)$$

# FIG. 5

# FIG. 6

# FIG. 7

[a]                    [b]

FIG. 8

FIG. 9

# FIG. 10

<table>
<tr><td colspan="2">

**INTERNATIONAL SEARCH REPORT**

</td><td>

International application No.

**PCT/JP2022/019826**

</td></tr>
</table>

**A. CLASSIFICATION OF SUBJECT MATTER**

*H01L 25/07*(2006.01)i; *H01L 25/18*(2006.01)i; *H02M 7/48*(2007.01)i
FI:    H01L25/04 C; H02M7/48 Z

According to International Patent Classification (IPC) or to both national classification and IPC

**B. FIELDS SEARCHED**

Minimum documentation searched (classification system followed by classification symbols)

H01L25/07; H01L25/18; H02M7/48

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2019/044748 A1 (MITSUBISHI ELECTRIC CORP) 07 March 2019 (2019-03-07) paragraphs [0097]-[0112], [0134]-[0152], fig. 20, 31-34 | 1, 4-6 |
| A | | 2-3 |
| A | WO 2020/054806 A1 (FUJI ELECTRIC CO., LTD.) 19 March 2020 (2020-03-19) paragraphs [0012]-[0043], fig. 1-7 | 2-3 |

☐ Further documents are listed in the continuation of Box C.        ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **28 July 2022** | **09 August 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2022/019826**

| Patent document cited in search report | | | Publication date (day/month/year) | Patent family member(s) | | | Publication date (day/month/year) |
|---|---|---|---|---|---|---|---|
| WO | 2019/044748 | A1 | 07 March 2019 | US paragraphs [0135]-[0150], [0170]-[0192], fig. 20, 31-34 CN | 2020/0185359 111033735 | A1 A | |
| WO | 2020/054806 | A1 | 19 March 2020 | US paragraphs [0023]-[0056], fig. 1-7 CN | 2020/0395344 111801795 | A1 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009278772 A

- JP 2020124030 A